# EUROPEAN PATENT APPLICATION

(11) **EP 4 575 482 A1**
(43) Date of publication of application: **25.06.2025**
(21) Application number: 24218676.5
(22) Date of filing: 10.12.2024
(51) Int. Cl.: G01N 27/22, H03M 1/46

(54) **PIXELATED CAPACITOR SENSOR CHARGE SHARING READOUT SYSTEM**

(30) Priority: 18.12.2023 US 202318543207
(71) Applicant: NXP B.V., 5656 AG Eindhoven (NL)
(72) Inventor: Litjes, Alphons, 5656AG Eindhoven (NL); Bhat, Ashwin, 5656AG Eindhoven (NL); Olieman, Erik, 5656AG Eindhoven (NL); Widdershoven, Franciscus Petrus, 5656AG Eindhoven (NL)
(74) Representative: Hardingham, Christopher Mark

(57) **Abstract**

Pixelated capacitive sensor systems and methods of operating pixelated capacitive sensor systems are provided. Pixelated capacitive sensor systems include a sensor array including a plurality of sense capacitors and a top plate, a comparator operatively connected to each sense capacitor and the top plate of the sensor array, a switch matrix operatively connected to each sense capacitor and the top plate of the sensor array, and a digital controller operatively connected to the comparator and the switch matrix. A read-out circuit may be formed by the sensor array, the comparator, the digital controller, and the switch matrix. Methods of operating pixelated capacitive sensor systems include providing a capacitive sensor system, sampling by the capacitive sensor system, toggling the sense capacitors by the digital controller, and running a conversion algorithm by the digital controller.

## Description

### FIELD OF THE DISCLOSURE

The present disclosure relates to pixelated capacitive sensor systems, and more particularly to pixelated capacitive sensor systems having sensor readout circuits that reuse the capacitive sensing cells for quantization.

### BACKGROUND OF THE DISCLOSURE

Capacitive sensors using Complementary Metal Oxide Semiconductor (CMOS) technology are used in various applications, such as life science applications. Currently known pixelated capacitive sensors consist of several pixel arrays, and a dedicated Analog to Digital Converter (ADC) for every row/column of pixels. Such ADCs are costly in both area, power, and complexity.

For at least one or more of these reasons, or one or more other reasons, it would be advantageous if new or improved systems could be developed, and/or improved methods of operation or implementation could be developed, so as to address any one or more of the concerns discussed above or to address one or more other concerns or provide one or more benefits.

### BRIEF DESCRIPTION OF THE DRAWINGS

Specific examples have been chosen for purposes of illustration and description, and are shown in the accompanying drawings, forming a part of the specification.
Figure 1 illustrates one example of a pixelated capacitive sensor system of the present technology.
Figure 2 illustrates an exploded view of the pixelated capacitive sensor system of Figure 1, with the housing removed.
Figure 3 (Prior Art) illustrates a diagram of one example of the operative components of a prior art pixelated capacitive sensor system.
Figure 4 illustrates the operative components of one embodiment of a pixelated capacitive sensor system of the present technology, which may be used in the pixelated capacitive sensor system of Figure 1.
Figure 5 illustrates a top view of the pixelated capacitive sensor array of the pixelated capacitive sensor system of Figure 4.
Figure 6 illustrates the operative components of a second embodiment of a pixelated capacitive sensor system of the present technology, which may be used in the pixelated capacitive sensor system of Figure 1, and which includes two sections of sense capacitors having different inks thereon.
Figure 7 illustrates a top view of the capacitive sensor array of the pixelated capacitive sensor system of Figure 6.
Figure 8 illustrates one example of a method of operating the pixelated capacitive sensor system of Figure 6.
Figure 9 is a graph of the top plate voltage during the method of Figure 8.
Figure 10 illustrates the operative components of a third embodiment of a pixelated capacitive sensor system of the present technology, which may be used in the pixelated capacitive sensor system of Figure 1, and which includes three sections of sense capacitors having different inks thereon.
Figure 11 illustrates a top view of the capacitive sensor array of the pixelated capacitive sensor system of Figure 10.
Figure 12 illustrates a diagram of a discovery phase logic engine for use in a pixelated capacitive sensor system of Figure 6 or Figure 10.
Figure 13 illustrates one example of a method of conducting a discovery phase for a pixelated capacitive sensor system of Figure 6 or Figure 10.

While various embodiments discussed herein are amenable to modifications and alternative forms, aspects thereof have been shown by way of example in the drawings and are described in detail herein. It should be understood, however, that the disclosure is not limited to the particular embodiments described, and instead is meant to include all modifications, equivalents, and alternatives falling within the scope of the disclosure. In addition, the terms "example" and "embodiment" as used throughout this application is only by way of illustration, and not limitation, the Figures are not necessarily drawn to scale, and the use of the same reference symbols in different drawings indicates similar or identical items unless otherwise noted. The term "configured to" as used herein with respect to a component being "configured to" have certain structural characteristics in specified circumstances or to perform a function means that the component is structurally formed such that the component meets the structural characteristics in the specified circumstances or performs the function without further modification. The term "about" as used herein with reference to any measurement or physical characteristic means approximately, and includes the stated measurement or physical characteristic plus or minus an amount that is within an acceptable margin of error or other amount of variance that maintains the desired functionality.

### DETAILED DESCRIPTION

Pixelated capacitive sensor systems of the present technology may be used in a variety of applications, particularly non-imaging applications, such as sampling certain amounts of substance over time. As compared to previously known Charge Redistribution (CR) Successive Approximate Registers (SARs), pixelated capacitive sensor systems of the present technology may reuse the capacitive sensing cells for quantization instead of a dedicated ADC. Such pixelated capacitor sensor charge sharing readout system may implement the sampling and part of the quantization function by reusing the pixel sensors as capacitive Digital to Analog Converters (DACs).

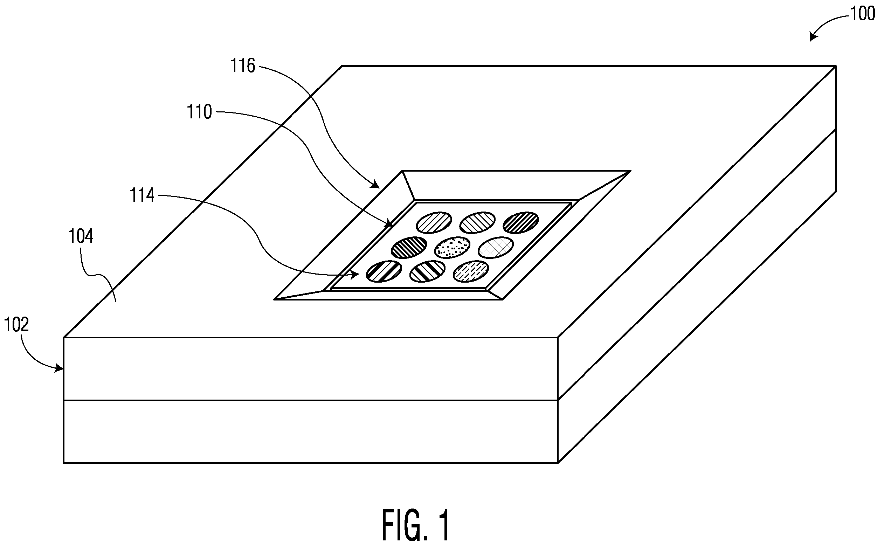

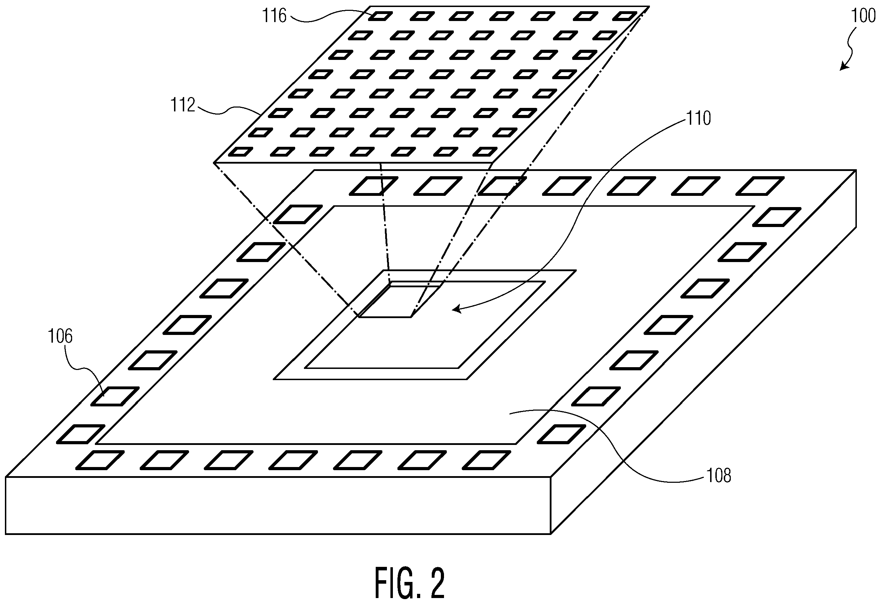

Figures 1 and 2 illustrate one example of a pixelated capacitive sensor system 100 of the present technology. The pixelated capacitive sensor system 100 may be in the form of a packaged chip 102, which includes a housing 104. For illustrative purposes, the housing 104 is not shown in Figure 2. As shown in Figure 2, the pixelated capacitive sensor system 100 includes a CMOS chip 106 having a digital controller 108, which can be a microcontroller, and a sense field 110 that includes an array of sense capacitors 112. The array of sense capacitors 112 includes a plurality of individual sense capacitors 116. One or more sensing inks 114 may be applied to the sense field 110. As shown in Figure 1, the one or more sensing inks 114 may be applied as dots on the sense field 110. In other examples, including examples discussed below, the one or more sensing inks 114 may be applied in areas of any shape on the sense field 110. In some examples the one or more sensing inks 114 may be printed onto the sense field 110, such as by inkjet printing. As shown in Figure 1, the housing 104 may include an access hole 116 that is configured to expose the sense field 112, but otherwise enclose at least the top of the CMOS chip 106.

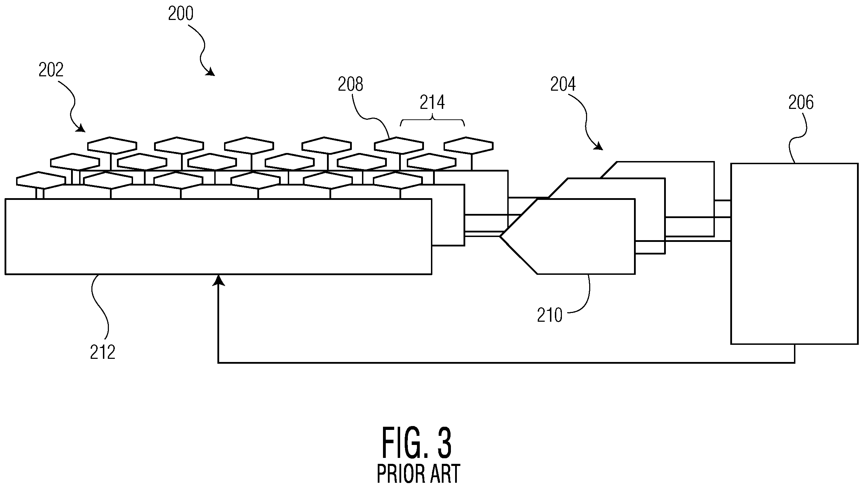

Figure 3 is a diagram of one example of the operative components of a prior art pixelated capacitive sensor system 200. The prior art pixelated capacitive sensor system 200 includes a sensor array 202, a read-out circuit 204, and a digital controller 206. The sensor array includes a plurality of sense capacitors 208, arranged in rows. The read-out circuit 204 includes a plurality of ADCs that function as sigma delta ADCs and perform decimation. Each row of sense capacitors 208 is operatively connected to one of the plurality of ADCs. The plurality of ADCs are each operatively connected to the digital controller 206. Each sense capacitor 208 is operatively connected to a switch matrix 212, which is operatively connected to the digital controller 206. As may be seen in Figure 3, in the prior art capacitive sensor system 200, the sensor array 202 and the read-out circuit 204 are two completely different circuits. During operation of the prior art pixelated capacitive sensor system 200, an input is sampled on the sensor array 202 and the resulting voltage is compared with a known reference voltage, and the digital controller 206 iteratively switches the sensor array 202 to determine the input sampled voltage. Capacitance is measured by the digital controller 206 selecting two sense capacitors 208 to form a capacitor 214, and measuring the capacitance between the two sense capacitors 208 using the appointed ADC.

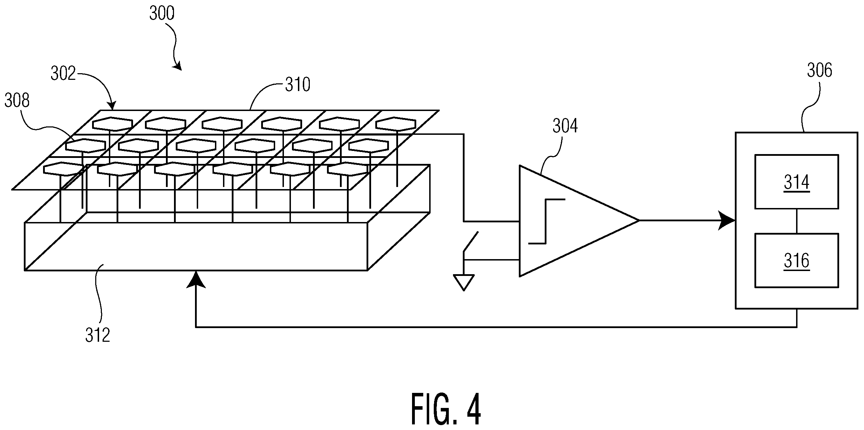

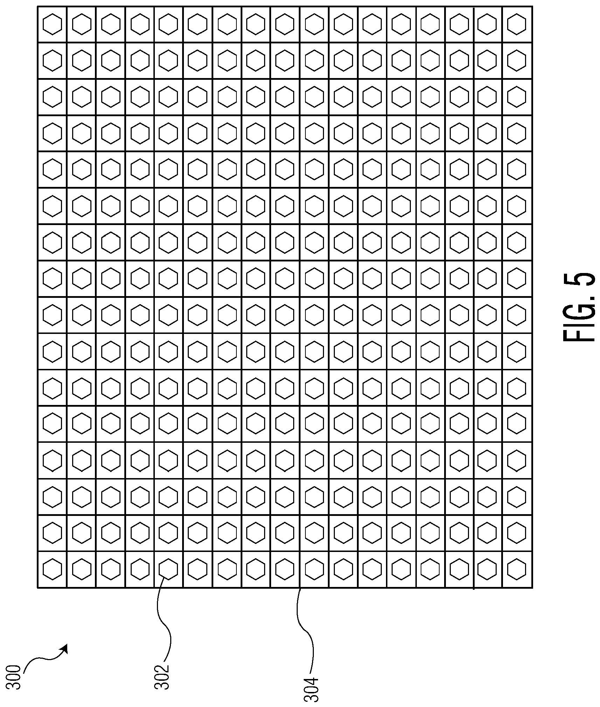

Figures 4 and 5 illustrate diagrams of portions of one example of a pixelated capacitive sensor system 300 of the present technology, which may be used in the pixelated capacitive sensor system 100. Figure 4 illustrates the operative components of the pixelated capacitive sensor system 300. Figure 5 illustrates a top view of the capacitive sensor array of the pixelated capacitive sensor system 300.

As shown in Figure 4, the pixelated capacitive sensor system 300 includes a sensor array 302, a comparator 304, and a digital controller 306. As shown in Figures 4 and 5, the sensor array 302 includes a plurality of sense capacitors 308 and a top plate 310, the top plate being part of the sense capacitors 308. Referring back to Figure 4, the top plate 310 is operatively connected to the comparator 304. The comparator 304 is operatively connected to the digital controller 306. Each of the sense capacitors 308 is also operatively connected to a switch matrix 312, which is operatively connected to the digital controller 306.

The read-out circuit of pixelated capacitive sensor system 300 is formed by the sensor array 302, the comparator 304, the digital controller 306, and the switch matrix 312. The digital controller includes a conversion logic 314 that includes a conversion algorithm, and additional logic 316. Additional logic 316 may include discovery phase logic that controls an initial discovery phase in examples where the sensor array 302 has sections of sense capacitors 308 that each have different inks on them (discussed in further detail below). The read-out circuit of pixelated capacitive sensor system 300 is formed by re-using the sensor array 302 as a capacitive digital to analog converter (DAC), and using the top plate 310 to provide the input voltage to be sensed.

During operation of the pixelated capacitive sensor system 300, capacitors are created by the digital controller 306 selecting a single or multiple sense capacitors 308 and the top plate 310. Then, the capacitance is measured by the digital controller 306 by successive approximation using the comparator 304 and the sensor array 302.

### Use of Two Inks

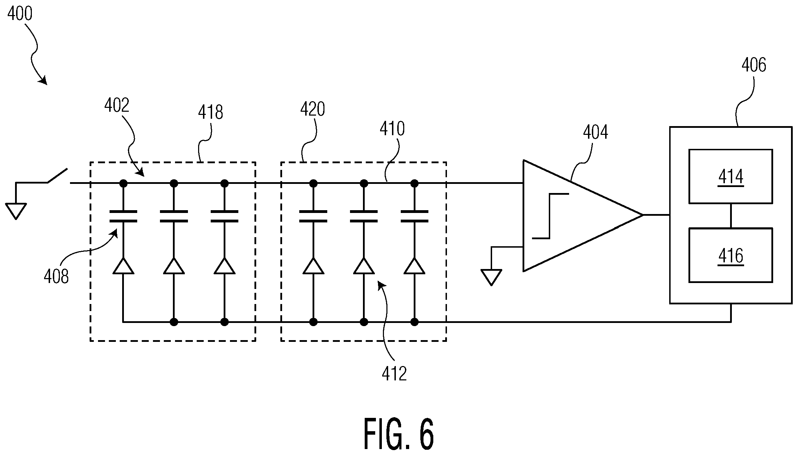

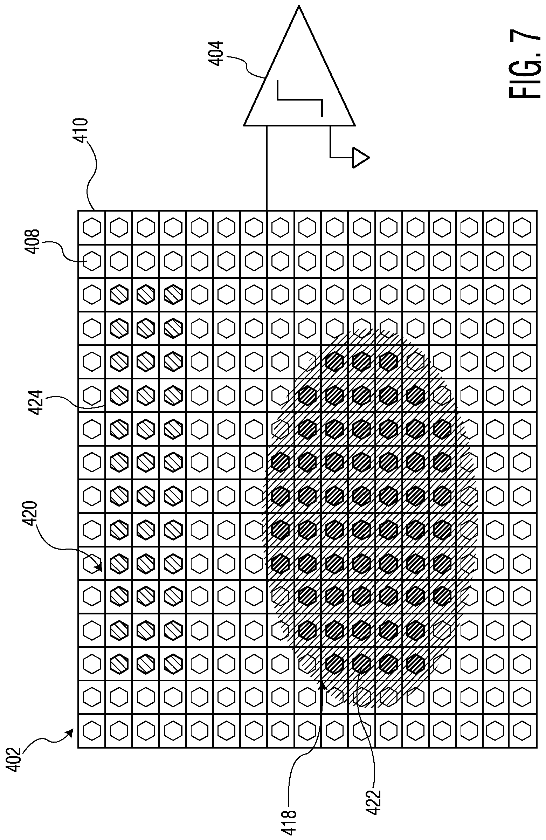

Figures 6 and 7 illustrate portions of an example of a pixelated capacitive sensor system 400 of the present technology where the sensor array has two sections of sense capacitors 408.

Figure 6 illustrates the operative components of the pixelated capacitive sensor system 400. Figure 7 illustrates a top view of the capacitive sensor array 402 of the pixelated capacitive sensor system 400. The components shown in Figures 6 and 7 of pixelated capacitive sensor system 400 may be used in the pixelated capacitive sensor system 100.

As shown in Figure 6, the pixelated capacitive sensor system 400 includes a sensor array 402, a comparator 404, and a digital controller 406. As shown in Figures 6 and 7, the sensor array 402 includes a plurality of sense capacitors 408 and a top plate 410, the top plate being part of the sense capacitors 308. Referring back to Figure 6, each of the top plate 410 is operatively connected to the comparator 404. The comparator 404 is operatively connected to the digital controller 406. Each of the sense capacitors 408 is also operatively connected to a switch matrix 412, which is operatively connected to the digital controller 406.

The digital controller 406 includes at least one processor and at least one non-transient computer readable memory that includes logic to control the processes of the pixelated capacitive sensor system 400. The digital controller 406 may include a conversion logic engine 414, which may control testing operations of the capacitive sensor system 400. The digital controller 406 may also include additional logic engines, which may include a discovery phase logic engine 416 that controls an initial discovery phase.

The read-out circuit of pixelated capacitive sensor system 400 is formed by the sensor array 402, the comparator 404, the digital controller 406, and the switch matrix 412. The read-out circuit of pixelated capacitive sensor system 400 is formed by re-using the sensor array 402 as a capacitive digital to analog converter (DAC), and using the top plate 410 to create a voltage which is compared to a reference voltage.

Referring to Figures 6 and 7, the sensor array 402 includes at least two sections, a first array section 418 and a second array section 420. The first array section 418 has a first set of sense capacitors 408, and there is a first ink 422, on the first set of sense capacitors 408 within the first array section 418. The second array section 420 has a second set of sense capacitors 408, and there is a second ink 424, on the second set of sense capacitors 408 within the second array section 420. The second array section 420 may be a reference array. Each ink may be printed on its respective array section, and may include a chemical reagent formulated to detect a pre-selected analyte. In at least one example, the first ink includes a first chemical reagent formulated to detect a first analyte, and the second ink includes a second chemical reagent formulated to detect a second analyte that is different from the first analyte. Thus with varying dielectric properties of the ink, due to its interaction with the analyte, the sensor capacitance is expected to change accordingly.

During operation of the pixelated capacitive sensor system 400, the average value of the capacitance of the capacitors in the first array section 418 may be compared as a function of the capacitance of the capacitors in the second array section 420, and visa-versa. The algorithm used may be similar to a calibration sequence where the weights of the first array section 418 are evaluated as compared to the second array section 420 by successive approximation.

### Conversion Method

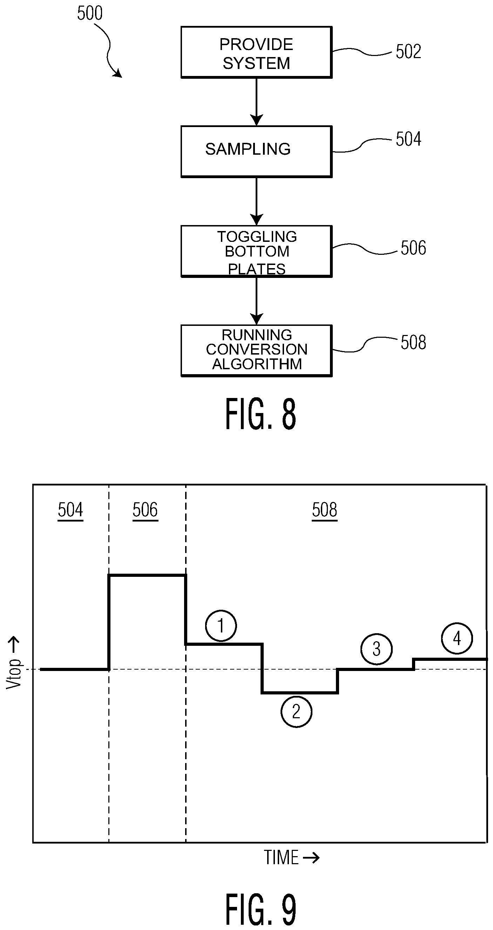

One method 500 of operating a pixelated capacitive sensor system is shown in Figure 8. The method 500 starts at step 502, which includes providing a capacitive sensor system. With reference to Figure 6, the provided capacitive sensor system is the pixelated capacitive sensor system 400, which includes the sensor array 402 including the plurality of sense capacitors 408 and the top plate 410, the comparator 404 operatively connected to the top plate 410 of the sensor array 402, the switch matrix 412 operatively connected to each sense capacitor 408 of the sensor array 402, and the digital controller 406 operatively connected to the comparator 404 and the switch matrix 412. The sensor array 402 includes at least two sections, the first array section 418 including a first set of sense capacitors and the second array section 420 including a second set of sense capacitors. Additionally, with reference to Figure 7, the first array section 418 has the first ink 422 on the first set of sense capacitors and the second array section 420 has the second ink 424 on the second set of sense capacitors.

Referring back to Figure 8, the method continues to step 504, which includes sampling by the digital controller 406. During sampling, the sense array 402 is exposed to substances, such as gases, being tested. With reference to Figure 7, during sampling, the digital controller 406 sets each sense capacitor 408 of the first array section 418 to a first value, and sets each sense capacitor 408 of the second array section 420 to a second value that is opposite of the first value, with these two complimentary values defined in the context of the whole system 400. Because the system is a binary system, the first value and the second value may be either 1 or 0. Accordingly, in one example, each sense capacitor 408 of the first array section 418 is set to a value of 0, and each sense capacitor 408 of the second array section 420 is set to a value of 1. At the same time, during sampling, the top-plate 410 is connected to a reference that is equal to the comparator reference voltage.

Referring back to Figure 8, the method then continues to step 506, which includes toggling the bottom plates. With reference to Figure 7, during the step of toggling the bottom plates, the top plate 410 is set to float, but still connected to the comparator. Toggling the bottom plates also includes the digital controller 406 operating the switch matrix 412 to switch the values of each sense capacitor 408 of the first array section 418 and each sense capacitor 408 of the second array section 420. Accordingly in the present example, during step 504, each sense capacitor 408 of the first array section 418 is set to a value of 1, and each sense capacitor 408 of the second array section 420 is set to a value of 0. If the capacitance of the first array section 418 and the second array section 420 are different, this will result in a voltage delta.

Referring back to Figure 8, the method then proceeds to step 508, which includes running the conversion algorithm. With reference to Figure 7, running the conversion algorithm includes the digital controller 406 determining which ratios of the first array section and the second array section need to be set to make the capacitance equal to each other, which happens when the top-plate voltage is equal to the reference voltage. As one example, if the digital controller 406 determines that the capacitance of the first array section 418 is equal to the capacitance of the second array section 420 when all of the sense capacitors 408 in the second array section 420 (the reference array section) remain toggled, and 76% of the sense capacitors 408 in the first array section 418 are toggled, it indicates that the second array section 420 is 76% of the size of the first array section 418 with respect to capacitance.

### Conversion Logic

Referring to Figures 6, 7, and 8, the digital controller 406 includes at least one non-transient computer readable memory that includes conversion logic 414, and at least one processor. When executed, the conversion logic causes the digital controller 406 to perform step 506, running the conversion algorithm. Running the conversion algorithm includes the digital controller 406 performing iterative comparisons of the average capacitance of a portion of the sense capacitors 408 of the first array section 418 to the average capacitance of a portion of the sense capacitors 408 of the second array section 420. During a first subset of the iterative phases, the portion of the sense capacitors 408 of the second array section 420 may be equal to all of the sense capacitors of the second array section.

Figure 9 is a graph of the top plate voltage during the method of Figure 8, as performed using one example of conversion logic 414 in a pixelated capacitive sensor system 400 shown in Figures 6 and 7, in which the first array section 418 and the second array section 420 each have 8 sense capacitors 408. As shown in the graph of Figure 9, during step 508, running the conversion algorithm includes four phases, first phase 1, second phase 2, third phase 3, and fourth phase 4. The four illustrated iterative phases may be a first subset of the total number of iterative phases. During each of the illustrated iterative phases, the digital controller 406 performs an iterative comparison of the average capacitance of a portion of the sense capacitors 408 of the first array section 418 to the average capacitance of all of the sense capacitors 408 of the second array section 420, as follows, where "C_unit_A" is the average capacitance of the portion of the first array section 418 indicated by the number in front of that term, and "C_unit_B" is the average capacitance of the portion of the second array section 420 indicated by the number in front of the term:
Phase 1: Is 8 * C_unit_A > 8 * C_unit_B?
Phase 2: Is 4 * C_unit_A > 8 * C_unit_B?
Phase 3: Is 6 * C_unit_A > 8 * C_unit_B?
Phase 4: Is 5 * C_unit_A > 8 * C_unit_B?

As shown above with respect to the illustrated four iterative phases, the number of sense capacitors in the portion of sense capacitors of the second array portion remained the same, in each phase being all eight of the sense capacitors of the second array portion. In contrast, the number of sense capacitors in the portion of sense capacitors of the first array portion stared with all eight sense capacitors of the first array section in Phase 1, and was reduced by one sense capacitor in each successive iterative phase. As illustrated in Figure 9, the result of the four illustrated iterative phases is that the average capacitance of the second array portion is somewhere between 5/8 and 6/8 of the average capacitance of the first array section, which is somewhere between 62.5% and 75% of the average capacitance of the first array section.

The iterative phases may also include a second subset of iterative phases after the first subset of iterative phases, in which the portion of the sense capacitors of the second array section is varied. For example, referring to Figure 9, further iterative phases may be:
Phase 5: Is 5 * C_unit_A > 7 * C_unit_B?
Phase 6: Is 4 * C_unit_A > 6 * C_unit_B?

In Phase 5 above, the digital controller 406 would determine whether the average capacitance of the second array section is more or less than 71.4% of the average capacitance of the first array section. If the answer to that is "no", then it must be somewhere between 62.5% and 71.4%. In Phase 6, the digital controller 406 then determines whether the average capacitance of the second array section is more or less than 66.7% of the average capacitance of the first array section. Accordingly, by using additional iterative phases that vary the portion of the sense capacitors of the second array section, a significantly more accurate value of the ratio between the unit capacitors in the first array section and the second array section is determined.

The above example is for just eight capacitors per array section. In examples having higher numbers of sense capacitors, a much more accurate ratio between the capacitances in the first array section and the second array section may be obtained.

### Use of More Than Two Inks

The present technology is not limited to the use of only two inks having chemical reagents. Any number of inks may be used. The sensor array will be divided into a number of array sections corresponding to the number of inks used.

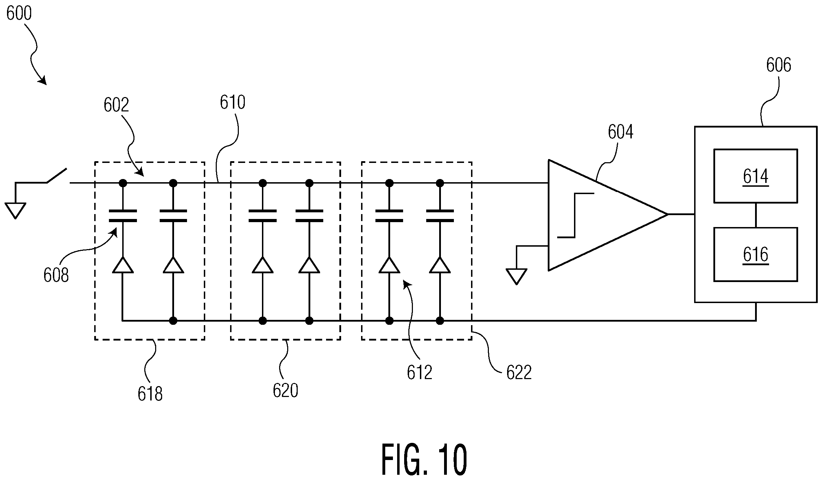

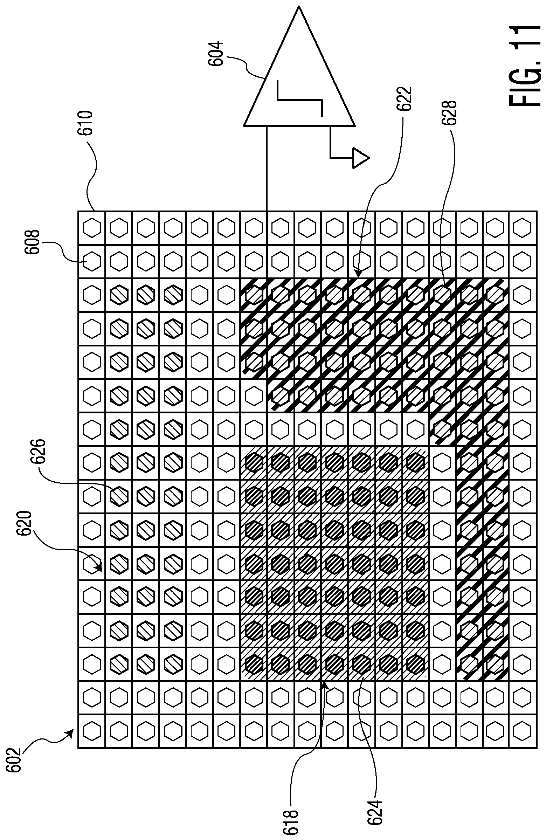

Figures 10 and 11 illustrate portions of an example of a pixelated capacitive sensor system 600 of the present technology where the sensor array has three sections of sense capacitors 608. In this example, there are three inks used, thus resulting in the three sections of sense capacitors 608. It should be understood that any number of inks, and any corresponding number of sections of sense capacitors could be used. Figure 10 illustrates the operative components of the pixelated capacitive sensor system 600. Figure 11 illustrates a top view of a capacitive sensor array 602 of the pixelated capacitive sensor system 600. The components shown in Figures 10 and 11 of pixelated capacitive sensor system 600 may be used in the pixelated capacitive sensor system 100.

As shown in Figure 10, the pixelated capacitive sensor system 600 includes the sensor array 602, a comparator 604, and a digital controller 606. As shown in Figures 10 and 11 the sensor array 602 includes a plurality of sense capacitors 608 and a top plate 610. Referring back to Figure 10, the top plate 610 is operatively connected to the comparator 604. The comparator 604 is operatively connected to the digital controller 606. Each of the sense capacitors 608 is operatively connected to a switch matrix 612, which is operatively connected to the digital controller 606.

The digital controller 606 includes at least one processor and at least one non-transient computer readable memory that includes logic to control the processes of the pixelated capacitive sensor system 600. The digital controller 606 may include a conversion logic engine 614, which may control testing operations of the capacitive sensor system 600. The digital controller 606 may also include additional logic engines, which may include a discovery phase logic engine 616 that controls an initial discovery phase.

The read-out circuit of pixelated capacitive sensor system 600 is formed by the sensor array 602, the comparator 604, the digital controller 606, and the switch matrix 612. The read-out circuit of pixelated capacitive sensor system 600 is formed by re-using the sensor array 602 as a capacitive digital to analog converter (DAC), and using the top plate 610 to create a voltage which is compared to a reference voltage.

Referring to Figures 10 and 11, the sensor array 602 includes at least three sections, a first array section 618, a second array section 620, and a third array section 622. As shown in Figure 11, the first array section 618 has a first set of sense capacitors 608, and there is a first ink 624, on the first set of sense capacitors 608 within the first array section 618. The second array section 620 has a second set of sense capacitors 608, and there is a second ink 626, on the second set of sense capacitors 608 within the second array section 620. The second ink 626 may be different from the first ink 624. The third array section 622 has a third set of sense capacitors 608, and there is a third ink 628, on the third set of sense capacitors 608 within the third array section 622. The third ink 628 may be different from each of the first ink 624 and the second ink 626. One of the array sections, such as second array section 620, may be a reference array. Each ink may be printed on its respective array section and may include a chemical reagent formulated to detect a pre-selected analyte. In at least one example, the first ink 624 includes a first chemical reagent formulated to detect a first analyte, the second ink 624 includes a second chemical reagent formulated to detect a second analyte that is different from the first analyte, and the third ink 628 includes a third chemical reagent formulated to detect a third analyte that is different from the first analyte and the second analyte.

During operation of the pixelated capacitive sensor system 600, the average value of the capacitance of the sense capacitors in any one array section may be determined as a fraction of the average capacitance of either of the other two array sections, using conversion logic similar to the conversion logic described with respect to the method 500 of operating a pixelated capacitive sensor system as shown in Figure 8.

### Discovery Phase Logic

The method 500 shown in Figure 8 may be implemented as long as the locations of each ink on the sensor array is known with specificity. Such a priori knowledge may be hardwired during manufacturing when inks are accurately applied, but such accuracy may not be achievable, or simply may not be known upon application. In practice, a discovery phase may be required after the inks including the chemical reagents are applied. Basically, the discovery phase includes scanning the entire sensor array and locating the different ink locations, which are then stored in the memory of the digital controller.

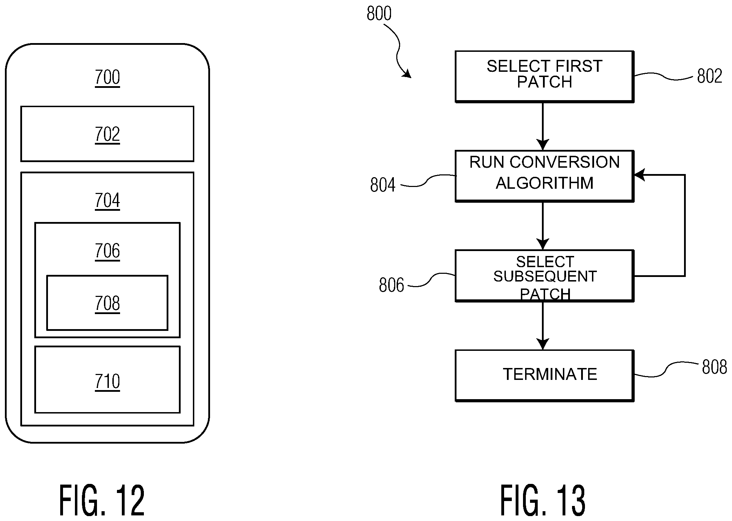

Accordingly, as shown in Figures 7 and 10 the digital controller 406/606 may include a discovery phase logic engine 416/616 that controls an initial discovery phase. Figure 12 illustrates a diagram of a discovery phase logic engine 700 for use in a pixelated capacitive sensor system of the present technology, such as being used as the discovery phase logic engine 416 in the pixelated capacitive sensor system 400 of Figure 6 or the discovery phase logic engine 616 in the pixelated capacitive sensor system 600 of Figure 10.

As shown in Figure 12, the discovery phase logic engine 700 may include a patch size control logic module 702 and a patch scan control logic module 704. The patch scan control logic module 704 may include row and column decoders 706, which may include timing units 708, and a local memory unit 710. The local memory unit 710 may, at least in part, include a local look up table that stores the average patch capacitance of each sense capacitor for further arithmetic operations. The look-up table may provide the reference capacitance values for future calibration and may also be used to determine the delta change in the capacitance once the sensor array is exposed to substances being tested during operation of the pixelated capacitive sensor system.

The method 500 of operating a pixelated capacitive sensor system as shown in Figure 8 may include one or more steps of conducting a discovery phase after step 502 and prior to step 504. Such steps are shown in Figure 13 as method 800.

The method 800 of conducting a discovery phase as shown in Figure 13 is described with respect to an example of the pixelated capacitive sensor system 400 of Figure 7 in which the second array section 420 is a reference array section that includes sense capacitors having the second ink in predetermined known locations. To ensure that the first ink is not applied to any of the sense capacitors in the second array area 420, the location of the second array section 420 may be defined as being outside the printable area of the first ink. There may also be sense capacitors that do not contain any ink, at least some of which may have a known location. The method 800 describes conducting discovery to determine the location of the sense capacitors in the first array section 418 that have the first ink 422.

The method 800 may begin with step 802, which includes selecting a first patch of sense capacitors within the area that may contain the first array section 418 that have the first ink 422. Referring to Figure 12, the step of selecting the first patch of sense capacitors may be conducted by the patch size control logic module 702. In the example shown in Figure 7, the first patch may be a small number of sense capacitors 408, such as three or four. The patch size could be varied depending upon the required spatial resolution of the location of the deposited chemical reagents.

Referring back to Figure 13, the method 800 may continue to step 804, which includes running a conversion algorithm with respect to the selected patch, and in this step specifically includes running the conversion algorithm to determine the average capacitance of the first patch. Running the conversion algorithm in the discovery phase may be similar to step 508 in Figure 8, and includes comparing the average capacitance of the first patch to the average capacitance of the second array section 420. Referring to Figure 12, running the conversion algorithm may be performed by the patch scan control logic module 704. The patch scan control logic module 704 may run the conversion algorithm using the row and column decoders 706, and the timing units 708. Data gathered and determined by the patch scan control logic module 704 while running the conversion algorithm, such as locations of the sense capacitors in the selected patch and whether they are determined to include the first ink, may be stored in the local memory unit 710.

Referring back to Figure 13, the method 800 may continue to step 806, which includes selecting a subsequent patch of sense capacitors within the area that may contain the first array section 418 that have the first ink 422. Typically, the subsequent patch of sense capacitors may include one or more different ones of the sense capacitors than the first patch of sense capacitors, albeit the subsequent patch of sense capacitors also may include one or more of the same sense capacitors comprised by the first patch of sense capacitors. Referring to Figure 12, the step of selecting the subsequent patch of sense capacitors may be conducted by the patch size control logic module 702.

Referring back to Figure 13, the method 800 may then go back to step 804 and run the conversion algorithm (or run an additional conversion algorithm) on the subsequent patch. The method 800 may loop repeatedly between steps 806 and 804, selecting one or more subsequent patches and running the conversion algorithm (or running additional conversion algorithms) on each of the subsequent patches, respectively, as long as there are additional sense capacitors that may be within the first array section 418.

During the discovery phase, a capacitance spatial map is built for the whole area of the sense array that may be included in the first array section 418 and have first ink 422. Referring to Figure 13, once the discovery phase is complete, the method 800 goes to step 808 and terminates. With reference to Figure 12, completion of the discovery phase may include the discovery phase logic engine 700 determining that there are no further sense capacitors in the sense array that may contain the first ink 422.

Notwithstanding the above description, the present disclosure is intended to encompass numerous embodiments including those disclosed herein as well as a variety of alternate embodiments.

Further, in at least some example embodiments encompassed herein, the present disclosure relates to pixelated capacitive sensor systems and methods of operating pixelated capacitive sensor systems. In at least one aspect, a pixelated capacitive sensor system is provided that include a sensor array including a plurality of sense capacitors and a top plate, a comparator operatively connected to each sense capacitor and the top plate of the sensor array, a switch matrix operatively connected to each sense capacitor and the top plate of the sensor array, and a digital controller operatively connected to the comparator and the switch matrix. In at least some such embodiments, a read-out circuit may be formed by the sensor array, the comparator, the digital controller, and the switch matrix.

In at least some examples, the sensor array may include at least two sections, a first array section including a first set of sense capacitors and a second array section including a second set of sense capacitors. The first array section may have a first ink on the first set of sense capacitors and the second array section may have a second ink on the second set of sense capacitors. In such examples, the first ink may include a first chemical reagent formulated to detect a first analyte, and the second ink includes a second chemical reagent formulated to detect a second analyte that is different from the first analyte.

In other examples, the sensor array may include at least three sections, a first array section including a first set of sense capacitors, a second array section including a second set of sense capacitors, and a third array section including a third set of sense capacitors. In such examples, the first array section may have a first ink on the first set of sense capacitors, the second array section may have a second ink on the second set of sense capacitors, and the third array section may have a third ink on the third set of sense capacitors. The first ink may include a first chemical reagent formulated to detect a first analyte, and the second ink may include a second chemical reagent formulated to detect a second analyte that is different from the first analyte, and the third ink may include a third chemical reagent formulated to detect a third analyte that is different from both the first analyte and the second analyte. The digital controller may include a conversion logic engine that includes a conversion algorithm and controls testing operations of the capacitive sensor system and may also include a discovery phase logic engine that controls an initial discovery phase to determine at least locations of sense capacitors in a first array section having a first ink.

In another aspect, methods of operating pixelated capacitive sensor systems are provided that include providing a capacitive sensor system, sampling by the capacitive sensor system, toggling the sense capacitors by the digital controller, and running the conversion algorithm by the digital controller. The capacitive sensor system provided may include a sensor array including a plurality of sense capacitors and a top plate, a comparator operatively connected to each sense capacitor and the top plate of the sensor array, a switch matrix operatively connected to each sense capacitor and the top plate of the sensor array, and a digital controller operatively connected to the comparator and the switch matrix. A read-out circuit may be formed by the sensor array, the comparator, the digital controller, and the switch matrix.

Also, in at least some such embodiments, sampling by the capacitive sensor system may include exposing the sensor array to at least one substance to be tested, Sampling may also include the digital controller connecting the top-plate to a reference that is equal to a comparator reference voltage, and setting each sense capacitor of a first array section to a first value and each sense capacitor of the second array section to a second value that is opposite of the first value. Toggling the sense capacitors by the digital controller may include setting the top plate to float, but still connected to the comparator's input, and operating the switch matrix to switch the values of each sense capacitor of the first array section from the first value to the second value and each sense capacitor of the second array section from the second value to the first value. Running the conversion algorithm by the digital controller may include determining by the digital controller which ratios of the first array section and the second array section need to be set to make the capacitance equal to each other. Running the conversion algorithm may include the digital controller performing a plurality of iterative phases, wherein each phase includes the digital controller comparing of the average capacitance of a portion of the sense capacitors of the first array section to the average capacitance of a portion of the sense capacitors of the second array section. The portion of the sense capacitors of the second array section during a first subset of the plurality of iterative phases may be equal to all of the sense capacitors of the second array section. Iterative phases may also include a second subset of iterative phases after the first subset of iterative phases, in which the portion of the sense capacitors of the second array section is varied.

The method may also include, prior to sampling by the digital controller, conducting a discovery phase by a discovery phase logic engine of the digital controller to determine at least locations of sense capacitors in a first array section having a first ink. Conducting the discovery phase may include selecting by a patch size control logic module of the discovery phase logic a first patch of sense capacitors within the area that may contain the first array section that have the first ink, running a conversion algorithm on the first patch by a patch scan control logic module of the discovery phase logic engine, selecting by a patch size control logic module of the discovery phase logic a subsequent patch of sense capacitors within the area that may contain the first array section that have the first ink, and running the conversion algorithm on the subsequent patch by a patch scan control logic module of the discovery phase logic engine.

One or more of the embodiments encompassed herein may be advantageous in any of a variety of respects. For example, pixelated capacitive sensor systems of the present technology may provide improvements relating to taking up less area and/or having improved efficiency with respect to power usage. Example embodiments that reuse the pixel sensors as a capacitive DAC may reduce the required hardware, which may result in reduction of production costs. Also, one or more embodiments encompassed herein may be implemented in or used in a variety of applications, such as biochemical applications and also imaging applications. At least some such biochemical applications may involve biosensors, such as where a chemical activation layer is printed on the pixels which bind certain substances and, if the substance is bound to the pixel, the capacitance will change and accordingly may be detected. Also, at least some example embodiments encompassed herein may be used as universal capacitive sensing interfaces where, for example, a chemical reagent is replaced by a micro-electromechanical system (MEMS) (and may become a gyroscope).

While the principles of the invention have been described above in connection with specific apparatus, it is to be clearly understood that this description is made only by way of example and not as a limitation on the scope of the invention. It is specifically intended that the present invention not be limited to the embodiments and illustrations contained herein, but include modified forms of those embodiments including portions of the embodiments and combinations of elements of different embodiments as come within the scope of the following claims.

## Claims

1. A capacitive sensor system comprising:
a sensor array including a plurality of sense capacitors and a top plate;
a comparator operatively connected to the top plate of the sensor array;
a switch matrix operatively connected to each sense capacitor of the sensor array; and
a digital controller operatively connected to the comparator and the switch matrix.

2. The capacitive sensor system of claim 1, further comprising a read-out circuit formed by the sensor array, the comparator, the digital controller, and the switch matrix.

3. The capacitive sensor system of claim 1 or 2, wherein the sensor array includes at least two sections, a first array section including a first set of sense capacitors and a second array section including a second set of sense capacitors; and
wherein the first array section has a first ink on the first set of sense capacitors and the second array section has a second ink on the second set of sense capacitors.

4. The capacitive sensor system of claim 3, wherein the first ink includes a first chemical reagent formulated to detect a first analyte, and the second ink includes a second chemical reagent formulated to detect a second analyte that is different from the first analyte.

5. The capacitive sensor system of any preceding claim, wherein the sensor array includes at least three sections, a first array section including a first set of sense capacitors, a second array section including a second set of sense capacitors, and a third array section including a third set of sense capacitors; and
wherein the first array section has a first ink on the first set of sense capacitors, the second array section has a second ink on the second set of sense capacitors, and the third array section has a third ink on the third set of sense capacitors.

6. The capacitive sensor system of claim 5, wherein the first ink includes a first chemical reagent formulated to detect a first analyte, and the second ink includes a second chemical reagent formulated to detect a second analyte that is different from the first analyte, and the third ink includes a third chemical reagent formulated to detect a third analyte that is different from both the first analyte and the second analyte.

7. The capacitive sensor system of any preceding claim, wherein the digital controller includes a conversion logic engine that controls testing operations of the capacitive sensor system.

8. The capacitive sensor system of claim 7, wherein the digital controller further includes discovery phase logic engine that controls an initial discovery phase to determine at least locations of sense capacitors in a first array section having a first ink.

9. A method of operating a capacitive sensor system, the method comprising:
providing a capacitive sensor system, the capacitive sensor system including:
a sensor array including a plurality of sense capacitors and a top plate;
a comparator operatively connected to the top plate of the sensor array;
a switch matrix operatively connected to each sense capacitor of the sensor array; and
a digital controller operatively connected to the comparator and the switch matrix;
wherein the sensor array includes at least two sections, a first array section including a first set of sense capacitors and a second array section including a second set of sense capacitors; and
wherein the first array section has a first ink on the first set of sense capacitors and the second array section has a second ink on the second set of sense capacitors;
sampling by the digital controller, including connecting the top plate to a reference that is equal to a comparator reference voltage, and setting each sense capacitor of a first array section to a first value and each sense capacitor of the second array section to a second value that is opposite of the first value;
toggling the sense capacitors by the digital controller, including setting the top plate to float, and operating the switch matrix to switch the values of each sense capacitor of the first array section from the first value to the second value and each sense capacitor of the second array section from the second value to the first value; and
running a conversion algorithm by the digital controller, including determining by the digital controller which ratios of the first array section and the second array section need to be set to make the capacitance equal to each other.

10. The method of claim 9, wherein running the conversion algorithm includes the digital controller performing a plurality of iterative phases, wherein each phase includes the digital controller comparing of an average capacitance of a portion of the sense capacitors of the first array section to an average capacitance of a portion of the sense capacitors of the second array section.

11. The method of claim 10, wherein the portion of the sense capacitors of the second array section during a first subset of the plurality of iterative phases is equal to all of the sense capacitors of the second array section.

12. The method of claim 11, wherein iterative phases include a second subset of iterative phases after the first subset of iterative phases, in which the portion of the sense capacitors of the second array section is varied.

13. The method of nay of claims 9 to 12, further comprising:
prior to sampling by the digital controller, conducting a discovery phase by a discovery phase logic engine of the digital controller to determine at least locations of sense capacitors in a first array section having a first ink.

14. The method of claim 13, wherein conducting the discovery phase includes:
selecting by a patch size control logic module of the discovery phase logic a first patch of sense capacitors within an area that may contain the first array section that have the first ink;
running the conversion algorithm on the first patch by a patch scan control logic module of the discovery phase logic engine;
selecting by a patch size control logic module of the discovery phase logic a subsequent patch of sense capacitors within the area that may contain the first array section that have the first ink; and
running the conversion algorithm on the subsequent patch by a patch scan control logic module of the discovery phase logic engine.

## Amended claims

### Amended claims in accordance with Rule 137(2) EPC.

1. A capacitive sensor system (300) comprising:
a sensor array (302) including a plurality of sense capacitors and a top plate;
a comparator (304) operatively connected to the top plate of the sensor array;
a switch matrix (312) operatively connected to each sense capacitor of the sensor array; and
a digital controller (306) operatively connected to the comparator and the switch matrix;
wherein the sensor array includes at least two sections, a first array section (418) including a first set of sense capacitors (408) and a second array section (420) including a second set of sense capacitors(408); and
wherein the first array section has a first ink (422) on the first set of sense capacitors and the second array section has a second ink (424) on the second set of sense capacitors;
wherein the capacitive sensor system is configured to:
sample (504) by the digital controller, including connecting the top plate to a reference that is equal to a comparator reference voltage, and setting each sense capacitor of a first array section to a first value and each sense capacitor of the second array section to a second value that is opposite of the first value;
toggle (506) the sense capacitors by the digital controller, including setting the top plate to float, and operating the switch matrix to switch the values of each sense capacitor of the first array section from the first value to the second value and each sense capacitor of the second array section from the second value to the first value; and
run (508) a conversion algorithm by the digital controller, including determining by the digital controller which ratios of the first array section and the second array section need to be set to make the capacitance equal to each other.

2. The capacitive sensor system of claim 1, further comprising a read-out circuit formed by the sensor array, the comparator, the digital controller, and the switch matrix.

3. The capacitive sensor system of claim 1 or 2, wherein the first ink includes a first chemical reagent formulated to detect a first analyte, and the second ink includes a second chemical reagent formulated to detect a second analyte that is different from the first analyte.

4. The capacitive sensor system of any preceding claim, wherein the sensor array includes at least three sections, a first array section including a first set of sense capacitors, a second array section including a second set of sense capacitors, and a third array section including a third set of sense capacitors; and
wherein the first array section has a first ink on the first set of sense capacitors, the second array section has a second ink on the second set of sense capacitors, and the third array section has a third ink on the third set of sense capacitors.

5. The capacitive sensor system of claim 4, wherein the first ink includes a first chemical reagent formulated to detect a first analyte, and the second ink includes a second chemical reagent formulated to detect a second analyte that is different from the first analyte, and the third ink includes a third chemical reagent formulated to detect a third analyte that is different from both the first analyte and the second analyte.

6. The capacitive sensor system of any preceding claim, wherein the digital controller includes a conversion logic engine that controls testing operations of the capacitive sensor system.

7. The capacitive sensor system of claim 6, wherein the digital controller further includes discovery phase logic engine that controls an initial discovery phase to determine at least locations of sense capacitors in a first array section having a first ink.

8. A method of operating a capacitive sensor system (300), the method comprising:
providing (502) a capacitive sensor system, the capacitive sensor system including:
a sensor array (302) including a plurality of sense capacitors (308) and a top plate (310);
a comparator (304) operatively connected to the top plate of the sensor array;
a switch matrix (312) operatively connected to each sense capacitor of the sensor array; and
a digital controller (306) operatively connected to the comparator and the switch matrix;
wherein the sensor array includes at least two sections, a first array section (418) including a first set of sense capacitors (408) and a second array section (420) including a second set of sense capacitors (408); and
wherein the first array section has a first ink (422) on the first set of sense capacitors and the second array section has a second ink (424) on the second set of sense capacitors;
sampling (504) by the digital controller, including connecting the top plate to a reference that is equal to a comparator reference voltage, and setting each sense capacitor of a first array section to a first value and each sense capacitor of the second array section to a second value that is opposite of the first value;
toggling (506) the sense capacitors by the digital controller, including setting the top plate to float, and operating the switch matrix to switch the values of each sense capacitor of the first array section from the first value to the second value and each sense capacitor of the second array section from the second value to the first value; and
running (508) a conversion algorithm by the digital controller, including determining by the digital controller which ratios of the first array section and the second array section need to be set to make the capacitance equal to each other.

9. The method of claim 8, wherein running the conversion algorithm includes the digital controller performing a plurality of iterative phases, wherein each phase includes the digital controller comparing of an average capacitance of a portion of the sense capacitors of the first array section to an average capacitance of a portion of the sense capacitors of the second array section.

10. The method of claim 9, wherein the portion of the sense capacitors of the second array section during a first subset of the plurality of iterative phases is equal to all of the sense capacitors of the second array section.

11. The method of claim 10, wherein iterative phases include a second subset of iterative phases after the first subset of iterative phases, in which the portion of the sense capacitors of the second array section is varied.

12. The method of nay of claims 8 to 11, further comprising:
prior to sampling by the digital controller, conducting a discovery phase by a discovery phase logic engine of the digital controller to determine at least locations of sense capacitors in a first array section having a first ink.

13. The method of claim 12, wherein conducting the discovery phase includes:
selecting by a patch size control logic module of the discovery phase logic a first patch of sense capacitors within an area that may contain the first array section that have the first ink;
running the conversion algorithm on the first patch by a patch scan control logic module of the discovery phase logic engine;
selecting by a patch size control logic module of the discovery phase logic a subsequent patch of sense capacitors within the area that may contain the first array section that have the first ink; and
running the conversion algorithm on the subsequent patch by a patch scan control logic module of the discovery phase logic engine.
